# EUROPEAN PATENT APPLICATION

(11) **EP 3 386 278 A1**
(43) Date of publication of application: **10.10.2018**
(21) Application number: 17382183.6
(22) Date of filing: 06.04.2017
(51) Int. Cl.: H05K 1/02, F21S 8/10

(54) **PRINTED CIRCUIT BOARD AND LIGHTING DEVICE**

(71) Applicant: Valeo Iluminacion, 23600 Martos (ES)
(72) Inventor: ROLDAN, Jose-David, 23600 Martos (ES); LARA-CABEZA, Juan, 23600 Martos (ES); MARTINEZ-PEREZ, Jose-Ramon, 23600 Martos (ES); BORREGO, Maria-Luisa, 23600 Martos (ES)

(57) **Abstract**

This invention relates to a printed circuit board (1) for an automated vehicle lighting device (10). This printed circuit board (1) comprises a first face (11), a second face (12) opposite to the first face (11), a first connection point (3) and a second connection point (4). The first connection point (3) is located on the first face (11) and is suitable for installing a light source (2), and the second connection point (4) is located on the second face (12) and is suitable for installing a light source (2).

## Description

### TECHNICAL FIELD

This invention belongs to the field of lighting devices installed in automotive vehicles, and more specifically to the printed circuit boards used in these lighting devices.

### STATE OF THE ART

Lighting devices installed in automotive vehicles usually comprise light sources mounted on a printed circuit board (PCB). Symmetrical PCB patterns are manufactured to adapt the PCBs to either the right-hand or the left-hand headlamp or rear lamp, since the electric connections and the thermal elements of the PCBs are in general intended to provide light sources on a single side of this PCB.

This duplicity of parts may entail some issues: as two different parts are required, two different references are needed and the manufacturing of two different pieces is necessary.

### DESCRIPTION OF THE INVENTION

The invention provides a solution for this problem by means of a printed circuit board according to claim 1 and a lighting device according to claim 6. Preferred embodiments of the invention are defined in dependent claims.

In an inventive aspect, the invention provides a printed circuit board for a lighting device, the printed circuit board comprising
a first face;
a second face opposite the first face;
a first connection point located on the first face, suitable for installing a light source;
a second connection point located on the second face, suitable for installing a light source.

A connection point should be understood as a zone electrically and occasionally thermally prepared to connect a light source. Electrical preparation may be provided, e.g., by means of a conductive track, and occasional thermal preparation may be provided, e.g., by means of a thermally conductor material which is intended to contact the light source and evacuate heat to a more favourable location.

The fact that a first and a second connection point are required in this PCB should also be understood as a single connection area which is accessible through both faces of the printed circuit board, so as two different connection points are available in fact, despite the connection itself is located in a single geometric point. For example, a through hole in the PCB would allow a light source to be connected in two different connection points, although it is possible that both connection points are fed by the same wire.

This printed circuit board allows the use of a single element for different functions. The design of the PCB has the advantage of manufacturing just one PCB model, instead of one model for each function.

In some particular embodiments, the first connection point opposes the second connection point with respect to the printed circuit board.

A printed circuit board according to one of these embodiments may be installed in different locations and performing different functions in the automotive vehicle, since connection points arranged to light in different directions provides the printed circuit board with a high versatility. This printed circuit board is specially indicated for symmetric applications.

In some embodiments,
the first connection point is located in a flat portion of the first face which defines a first plane, and the second connection point is located in a flat portion of the second face which defines a second plane; and
the first and the second connection points are located symmetrically with respect to a plane which is equidistant to the first plane and to the second plane.

The symmetry in the location of the connection points makes a single PCB able to be used for two twin lamps, as they provide a symmetric operation profile.

In some embodiments, the printed circuit board further comprises at least one thermal track in thermal contact with the first connection point and with the second connection point.

This embodiment allows a connection point to benefit from heat dissipation means which are associated to the other connection point, since the thermal tracks make that a connection point is also in thermal contact with the heat dissipation means associated to the other connection point.

In some embodiments, the printed circuit board further comprises first heat dissipation means which are in thermal contact with the first connection point, and second dissipation means which are in thermal contact with the second connection point.

This embodiment provides for sufficient heat dissipation to both connection points. In the event that the PCB receives a LED light source, these dissipation means are important for the correct operation of these light sources.

In some embodiments, the first heat dissipation means are located on the second face of the printed circuit board, and the second heat dissipation means are located on the first face of the printed circuit board.

This location of the heat dissipation means, in the opposite face from the face of the connection point, is advantageous, since, as no light sources are connected at the same time in opposite faces of the printed circuit board, the opposite face is always free, thus providing a better heat dissipation.

In another inventive aspect, the invention provides a lighting device comprising
a printed circuit board according to any of the preceding claims; and
a light source in electrical contact with either the first connection point or the second connection point.

In some embodiments, the light source is arranged in electrical contact with either the first connection point or the second connection point by means of an auxiliary wire.

These embodiments comprise a light source remotely located from the connection point, and electrically attached to it by means of an auxiliary conductive wire. This practice (generally known as "submount") allows the placement of the light source wherever it is needed, without the location restriction imposed by the printed circuit board.

In some embodiments, the lighting device is a fog lamp or a daytime running light (DRL).

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a schematic view of lamps as known in the state of the art.
Figure 2 shows a side view of a printed circuit board according to the invention.
Figure 3 shows two lighting devices according to the invention, installed in an automotive vehicle.

### DETAILED DESCRIPTION OF THE INVENTION

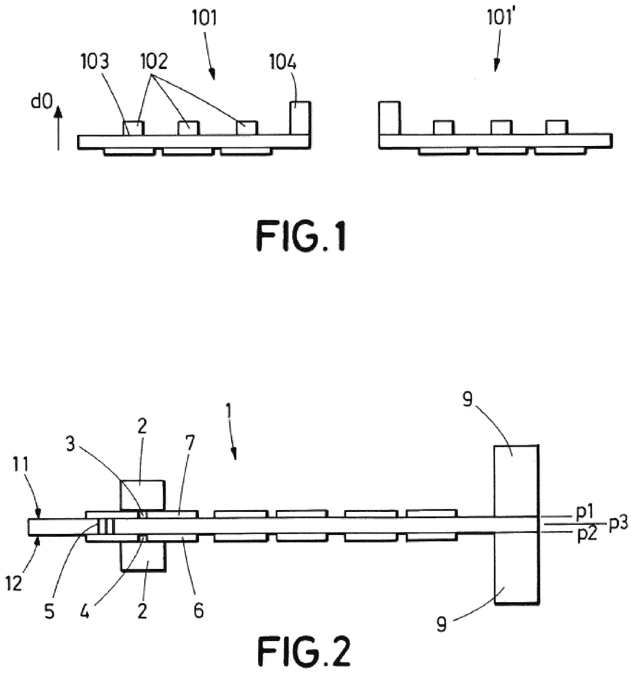

Figure 1 shows a schematic view of two daytime running light (DRL) lamps. Left lamp and right lamp have a symmetrical pattern, and therefore, symmetrical PCBs 101, 101' are used. Each PCBs comprises connection points 103, where LEDs 102 are installed, and one connector 104 to connect the printed circuit board 101 to the DRL lamp. When the LEDs are installed in the connection points 103, LEDs 102 are oriented in the same direction d0, as light is emitted in this single direction.

Figure 2 shows a side view of a printed circuit board 1 according to the invention. This printed circuit board 1 comprises
a first connection point 3, suitable for installing a light source 2; and
a second connection point 4, suitable for installing a light source 2.

This printed circuit board 1 comprises a first face 11 and a second face 12, opposite to the first face 11. The first connection point 3 is located in the first face 11 and the second connection point 4 is located in the second face 12.

The printed circuit board has therefore connection points that allow the installation of light sources 2 in opposite faces of the PCB, and consequently the light sources may be oriented in different, namely opposite, directions. This makes that a single PCB may be used in different parts of the vehicle and/or provide different functions.

Both first 3 and second 4 connection points accept the installation of a light source, but the printed circuit board 1 is not intended to receive both light sources at the same time. As a consequence, the first heat dissipation means 6, which are in thermal contact with the first connection point 3, are located on the second face 12 of the printed circuit board 1. This location is chosen because, since the second face 12 is free when the first face 11 receives light sources, the second face 12 has more free surface to dissipate heat, making this location of the first heat dissipation means more efficient. The same thing may be said, mutatis mutandis, with the second heat dissipation means 7, arranged on the first face 11 of the printed circuit board 1. Further, different connectors 9 may be installed either in the first face 11 or in the second face 12 of this printed circuit board, although they are not installed at the same time, since only one is necessary for each application.

To connect each of the connection points to its corresponding location of the heat dissipation means, the printed circuit board 1 of this figure provides thermal tracks 5. These thermal tracks may go inside or outside the printed circuit board, and makes the heat generated in the first connection point 3 be transmitted to the first heat dissipation means 6 and the heat generated in the second connection point 4 be transmitted to the second heat dissipation means 7.

As may be seen in this figure, the first connection point 3 is located in a flat portion of the first face 11 which defines a first plane p1, and the second connection point 4 is located in a flat portion of the second face which defines a second plane p2. When a light source 2 is installed in the second connection point 4, it is oriented in a second direction d2 which forms 180º with a first direction d1 which a light source 2 installed in the first connection point 3 is oriented in.

Further, the first connection point 3 and the second connection point 4 are located symmetrically with respect to a third plane p3 which is equidistant to the first plane p1 and to the second plane p2.

In the particular embodiment shown in this figure, the light source 2 is arranged in electrical contact with either the first connection point 3 or the second connection point 4 by means of an auxiliary wire 8. In other embodiments, the light source 2 is arranged directly in contact with the first connection point 3 or the second connection point 4.

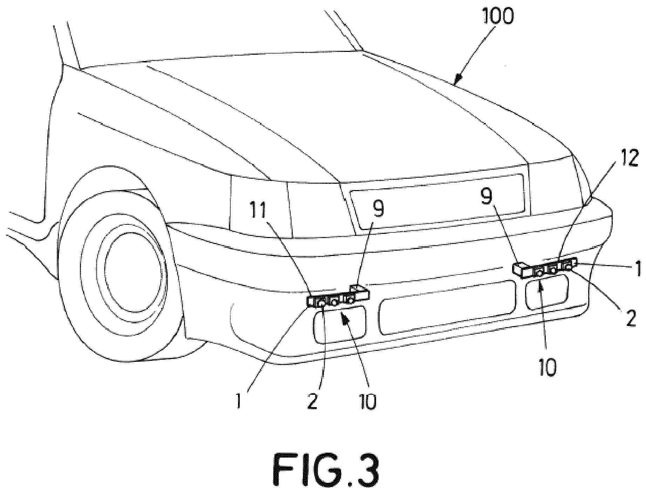

Figure 3 shows two lighting devices 10 according to the invention, installed as foglamps in an automotive vehicle 100. Each lighting device 10 comprises
a printed circuit board 1 according to any of the preceding claims; and
a light source 2 in electrical contact with either the first connection point 3 or the second connection point 4.

In this figure, it may be seen the main advantage of this PCB: the same PCB may be used in left DRL and in right DRL. In the left lamp, the PCB 1 is used with the LEDs connected in the first face 11. In the right lamp, an identical PCB 1 is used with the LEDs connected in the second face 12. The same PCB is therefore used for symmetrical uses. It is noted that a completely symmetrical arrangement is not always required to take advantage of the invention - as stated before, the fact that opposite faces of the printed circuit board can indistinctly be used to support connection points makes a single printed circuited board versatile for different automotive lighting functions.

## Claims

1. Printed circuit board (1) for an automated vehicle lighting device (10), the printed circuit board (1) comprising
a first face (11);
a second face (12) opposite the first face (11);
a first connection point (3) located on the first face (11), suitable for installing a light source (2);
a second connection point (4) located on the second face (12), suitable for installing a light source (2)
wherein the first connection point (3) opposes the second connection point (4) with respect to the printed circuit board (1).

2. Printed circuit board (1) according to claim 1, wherein
the first connection point (3) is located in a flat portion of the first face (11) which defines a first plane (p1), and the second connection point (4) is located in a flat portion of the second face which defines a second plane (p2); and
the first (3) and the second (4) connection points are located symmetrically with respect to a plane which is equidistant to the first plane (p1) and to the second plane (p2).

3. Printed circuit board (1) according to any of the preceding claims, further comprising at least one thermal track (5) in thermal contact with the first connection point (3) and with the second connection point (4).

4. Printed circuit board (1) according to any of the preceding claims, further comprising first heat dissipation means (6) which are in thermal contact with the first connection point (3), and second dissipation means (7) which are in thermal contact with the second connection point (4).

5. Printed circuit board (1) according to claim 4, wherein the first heat dissipation means (6) are located on the second face (12) of the printed circuit board (1), and the second heat dissipation means (7) are located on the first face (11) of the printed circuit board (1).

6. Lighting device (10) comprising
a printed circuit board (1) according to any of the preceding claims; and
a light source (2) in electrical contact with either the first connection point (3) or the second connection point (4), the light source (2) being adapted to emit a light beam.

7. Lighting device (10) according to claim 6, wherein the light source (2) is arranged in electrical contact with either the first connection point (3) or the second connection point (4) by means of an auxiliary wire (8).

8. Lighting device (10) according to any of claims 6 or 7, the lighting device further comprising a first optical element, being arranged and configured to shape the light beam received from the light source (2) in a predetermined light pattern.

9. Lighting device (10) according to any of preceding claims, the lighting device (10) being a fog lamp or a daytime running lamp.
